# EUROPEAN PATENT APPLICATION

(11) **EP 1 930 732 A1**
(43) Date of publication of application: **11.06.2008**
(21) Application number: 06782146.2
(22) Date of filing: 02.08.2006
(51) Int. Cl.: G01P 21/00, H01L 21/027

(54) **MINUTE STRUCTURE INSPECTION DEVICE, INSPECTION METHOD, AND INSPECTION PROGRAM**

(30) Priority: 04.08.2005 JP 2005226867
(71) Applicant: TOKYO ELECTRON LIMITED, Minato-ku Tokyo 107-8481 (JP)
(72) Inventor: IKEUCHI, Naoki c/o Tokyo ELectron AT Limited, Hyogo 6600891 (JP)
(74) Representative: Goddar, Heinz J.
(86) International application number: PCT/JP2006/315277
(87) International publication number: WO 2007/015506

(57) **Abstract**

There are provided an inspection device, an inspection method, and an inspection program for accurately inspecting a minute structure having a movable portion by using a simple method. A test sound wave is inputted and frequency characteristic of a sensor output voltage amplitude responding to the input of the test sound wave is analyzed. The maximum frequency and the minimum frequency of the device is calculated from estimated use conditions and it is judged whether it is possible to detect a desired characteristic in the frequency band. More specifically, the device is judged to be good or bad depending whether the response characteristic in a predetermined frequency band exceeds the minimum characteristic level as a threshold value.

## Description

### FIELD OF THE INVENTION

The present invention relates to an inspection device, inspection method, and inspection program for inspecting a minute structure such as MEMS (Micro Electro Mechanical System).

### BACKGROUND OF THE INVENTION

In recent years, MEMS that is a device into which various functions such as mechanical, electronic, optical, and chemical functions, and other functions are integrated with the use of a semiconductor micromachining technique has been attracting attention. As a MEMS technology having been put into practical use, for example, MEMS devices are incorporated into an acceleration sensor, pressure sensor, airflow sensor, and other sensors, which are all micro sensors as various sensors for automotive and medical uses. Also, employing the MEMS technology for an ink-jet printing head enables a nozzle for ejecting ink to be increased in number as well as enabling the ink to be precisely ejected, so that image quality can be improved and also printing speed can be increased. Further, a micro mirror array, or the like, used in a reflection type projector is known as a typical MEMS device.

Also, it is expected for further development of various sensors and actuators using the MEMS technology to lead to applications to optical communication/mobile devices, and peripheral devices of a computer, and further applications to bioanalyses and portable power supplies. Technology Survey Report No. 3 titled "Present status of MEMS technology and related issues" (issued by Technology Evaluation and Research Division, Industrial Science and Technology Policy and Environment Bureau, and Industrial Machinery Division, Manufacturing Industries Bureau of Ministry of Economy, Trade and Industry of Japan, March 28, 2003) introduces various MEMS technologies.

On the other hand, along with the development of MEMS devices, an inspection method for appropriately inspecting the MEMS devices becomes important because of their minute structures. Characteristics of the device have conventionally been evaluated by rotating the device or by means of vibration after packaging; however, by performing an appropriate inspection to detect defects in an initial stage such as a state of a wafer after application of the micromachining technique, yield can be improved and manufacturing cost can be more reduced.

As an example, Japanese published unexamined patent application No. H05-34371 proposes an inspection method comprising determining a characteristic of an acceleration sensor formed on a wafer by detecting a resistance value of the acceleration sensor, which is varied by blowing air toward the acceleration sensor.
Patent document 1: Japanese published unexamined patent application No. H05-34371
Nonpatent document 1: Technology Survey Report No. 3 (issued by Technology Evaluation and Research Division, Industrial Science and Technology Policy and Environment Bureau, and Industrial Machinery Division, Manufacturing Industries Bureau of Ministry of Economy, Trade and Industry of Japan, March 28, 2003)

In general, a structure having a minute movable portion, such as the acceleration sensor, is a device having a response characteristic that is varied in response to even minute movement. Accordingly, in order to evaluate the characteristic, accurate inspection is required. As described in the above publication of unexamined patent application, even in the case where the device is varied (slightly in structure), fine adjustment should be performed to evaluate the characteristic of the acceleration sensor; however, highly accurate inspection is extremely difficult to perform under the condition that a flow rate of gas is controlled and the gas is uniformly blown toward the device, and even if the inspection is performed, a complicated and expensive tester has to be provided.

Further, in the case of the blowing of air, highly accurate inspection is difficult to perform with the air being made to have directivity, and blown toward a specific position.

The present invention is made to solve the problems as described above, and has an object to provide an inspection device, inspection method, and inspection program for accurately inspecting a minute structure having a minute movable portion in a simple manner.

### SUMMARY OF THE INVENTION

A minute structure inspection device according to the present invention is one for evaluating a characteristic of at least one minute structure having a movable portion, the minute structure being formed on a substrate, and comprises: sound wave generating means adapted to output a test sound wave to said minute structure upon testing; and evaluating means adapted to detect movement of said movable portion of said minute structure in response to said test sound wave outputted by said sound wave generating means, and evaluate said characteristic of said minute structure on a basis of a result of the detection. Said evaluating means evaluates said characteristic of said minute structure on a basis of a comparison between an output voltage outputted on a basis of said movement of said movable portion of said minute structure in at least one given frequency band and an output voltage corresponding to a given threshold.

Preferably, said given threshold has a first threshold determination level and a second threshold determination level in said given frequency band; and said evaluating means determines said minute structure to be a good item upon a frequency response characteristic of said outputted output voltage being included between said first and second determination threshold levels in said given frequency band.

Preferably, said given threshold has a plurality of threshold determination levels in said given frequency band; and said evaluating means divides a distribution in frequency response characteristic of said outputted output voltage in said given frequency band into a plurality of groups on a basis of said plurality of threshold determination levels, and evaluates quality on a basis of one of said plurality of groups, the one being belonged to by a frequency response characteristic of said outputted output voltage.

Preferably, said evaluating means divides a distribution in frequency response characteristic of said outputted output voltage in said given frequency band into a plurality of frequency band groups, and evaluates quality on a basis of one of said plurality of frequency band group, the one being belonged to by a frequency response characteristic of said outputted output voltage.

Preferably, said test sound wave has any single frequency.
Preferably, said test sound wave has a plurality of any different frequencies.

In particular, said test sound wave corresponds to white noise.
A minute structure inspection device according to the present invention is one for evaluating a characteristic of at least one minute structure having a movable portion, the minute structure being formed on a substrate, and comprises: driving means adapted to electrically provide movement to said movable portion of said minute structure; and evaluating means adapted to detect sound outputted in response to said movement of said minute structure, and evaluate said characteristic of said minute structure on a basis of a result of the detection. Said evaluating means evaluates said characteristic of said minute structure on a basis of a comparison between an output sound pressure outputted on a basis of said movement of said movable portion of said minute structure in at least one given frequency band and an output sound pressure corresponding to a given threshold.

Preferably, said given threshold has a first threshold determination level and a second threshold determination level in said given frequency band. Said evaluating means determines said minute structure to be a good item upon a frequency response characteristic of said outputted output sound pressure being included between said first and second threshold determination levels in said given frequency band.

Preferably, said given threshold has a plurality of threshold determination levels in said given frequency band. Said evaluating means divides a distribution in frequency response characteristic of said outputted output sound pressure in said given frequency band into a plurality of groups on a basis of said plurality of threshold determination levels, and evaluates quality on a basis of one of said plurality of groups, the one being belonged to by a frequency response characteristic of said outputted output sound pressure.

Preferably, said evaluating means divides a distribution in frequency characteristic of said outputted output sound pressure in said given frequency band into a plurality of frequency band groups, and evaluates quality on a basis of one of said plurality of frequency band groups, the one being belonged to by a frequency response characteristic of said outputted output sound pressure.

A minute structure inspection method according to the present invention is one for evaluating a characteristic of at least one minute structure having a movable portion, the minute structure being formed on a substrate, and comprises the steps of: outputting a test sound wave to said minute structure upon testing; detecting movement of said movable portion of said minute structure in response to said test sound wave outputted by sound wave generating means; and evaluating said characteristic of said minute structure on a basis of a result of the detection. Said evaluating step evaluates said characteristic of said minute structure on a basis of a comparison between a detected output voltage in at least one given frequency band and an output voltage corresponding to a given threshold.

Preferably, said given threshold has a first threshold determination level and a second threshold determination level in said given frequency band. Said evaluating step determines said minute structure to be a good item upon a frequency response characteristic of said detected output voltage being included between said first and second threshold determination levels in said given frequency band.

Preferably, said given threshold has a plurality of threshold determination levels in said given frequency band. A distribution in frequency response characteristic of said detected output voltage in said given frequency band is divided into a plurality of groups on a basis of said plurality of threshold determination levels. Said evaluating step evaluates quality on a basis of one of said plurality of groups, the one being belonged to by a frequency response characteristic of said detected output voltage.

Preferably, a distribution in frequency response characteristic of said detected output voltage in said given frequency band is divided into a plurality of frequency band groups. Said evaluating step evaluates quality on a basis of one of said plurality of frequency band groups, the one being belonged to by a frequency response characteristic of said detected output voltage.

Preferably, said test sound wave has any single frequency.
Preferably, said test sound wave has a plurality of any different frequencies.

In particular, said test sound wave corresponds to white noise.
A minute structure inspection method according to the present invention is one for evaluating a characteristic of at least one minute structure having a movable portion, the minute structure being formed on a substrate, and comprises the steps of: electrically providing movement to said movable portion of said minute structure; detecting sound outputted in response to said movement of said minute structure; and evaluating said characteristic of said minute structure on a basis of a result of the detection. Said evaluating step evaluates said characteristic of said minute structure on a basis of a comparison between a detected output sound pressure in at least one given frequency band and an output sound pressure corresponding to a given threshold.

Preferably, said given threshold has a first threshold determination level and a second threshold determination level in said given frequency band. Said evaluating step determines said minute structure to be a good item upon a frequency response characteristic of said detected output sound pressure being included between said first and second threshold determination levels in said given frequency band.

Preferably, said given threshold has a plurality of threshold determination levels in said given frequency band. A distribution in frequency response characteristic is divided into a plurality of groups on a basis of said plurality of threshold determination levels for said detected output sound pressure in said given frequency band. Said evaluating step evaluates quality on a basis of one of said plurality of groups, the one being belonged to by a frequency response characteristic of said detected output sound pressure in said given frequency band.

Preferably, a distribution in frequency response characteristic of said detected output sound pressure in said given frequency band is divided into a plurality of frequency band groups. Said evaluating step evaluates quality on a basis of one of said plurality of frequency band groups, the one being belonged to by a frequency response characteristic of said detected output sound pressure.

A minute structure inspection program according to the present invention instructs a computer to execute any one of the above-described minute structure inspection methods.

A minute structure inspection device according to the present invention is one for evaluating a characteristic of at least one minute structure having a movable portion, the minute structure being formed on a substrate, and comprises: driving means adapted to electrically provide movement to said movable portion of said minute structure; and evaluating means adapted to detect sound outputted in response to said movement of said minute structure, and evaluate said characteristic of said minute structure on a basis of a result of the detection. Said evaluating means calculates an occupied area of a given region surrounded by an output sound pressure characteristic based on said movement of said movable portion of said minute structure, to thereby calculate an occupancy rate, the output sound pressure characteristic being between a minimum characteristic level and a maximum characteristic level and in a given frequency band, and evaluates said characteristic of said minute structure on a basis of a comparison between said occupancy rate and an occupancy rate corresponding to a given threshold.

The minute structure inspection device, inspection method, and inspection program according to the present invention output the test sound wave to the minute structure upon testing, and evaluate the characteristic of the minute structure from the frequency response characteristic of the variable varying on the basis of the movement of the movable portion of the minute structure in response to the test sound wave, and therefore can accurately inspect the minute structure having the minute movable portion in a simple manner.

Also, the another minute structure inspection device, inspection method, and inspection program according to the present invention: electrically provide the movement to the movable portion of the minute structure; detect the sound outputted in response to the movement of the minute structure; and evaluate the characteristic of the minute structure from the frequency response characteristic of the detected sound pressure. That is, they evaluate the characteristic of the minute structure on the basis of the frequency response characteristic, and therefore can accurately inspect the minute structure having the minute movable portion in a simple manner.

### BRIEF DESCRIPTION OF THE DRAWINGS

Fig. 1 is a schematic configuration diagram of a minute structure inspection system 1 according to Embodiment 1 of the present invention.

Fig. 2 is a diagram of a triaxial acceleration sensor as viewed from above the device.

Fig. 3 is a schematic diagram of the triaxial acceleration sensor.

Fig. 4 is a conceptual diagram illustrating weights and deformations of beams for the case of experience of acceleration in each of axial directions.

Fig. 5 is a circuit configuration diagram of the Wheatstone bridge provided for each of axes.

Fig. 6 is a diagram illustrating output response of the triaxial acceleration sensor versus a tilt angle.

Fig. 7 is a diagram illustrating a relationship between gravitational acceleration (input) and sensor output.

Fig. 8 is a diagram illustrating frequency characteristics of the triaxial acceleration sensor.

Fig. 9 is a flowchart illustrating a minute structure inspection method according to Embodiment 1 of the present invention.

Fig. 10 is a diagram illustrating the frequency response of the triaxial acceleration sensor in response to a test sound wave outputted from a speaker 2.

Fig. 11 is a diagram illustrating a method for allowable range based determination according to Embodiment 1 of the present invention.

Fig. 12 is a diagram illustrating another method for allowable range based determination according to Embodiment 1 of the present invention.

Fig. 13 is a diagram illustrating still another method for allowable range based determination according to Embodiment 1 of the present invention.

Fig. 14 is a diagram illustrating a case where the allowable range based determination of a sensor output voltage is made with thresholds being changed within a given frequency band.

Fig. 15 is a diagram illustrating a case where the allowable range based determination of the sensor output voltage is made on the basis of an area ratio.

Fig. 16 is a diagram illustrating a case where the allowable range based determination of the sensor output voltage is made with the use of a resonance point of the device.

Fig. 17 is a schematic configuration diagram of a minute structure inspection system 1# according to Embodiment 2 of the present invention.

Fig. 18 is a diagram illustrating a case where a membrane structure is used for an irradiation window of an electron beam irradiator.

Fig. 19 is a flowchart illustrating a minute structure inspection method according to Embodiment 2 of the present invention.

Fig. 20 is a conceptual diagram illustrating a part of the minute structure inspection system 1# according to Embodiment 2 of the present invention.

Fig. 21 is a diagram illustrating in detail a measuring jig 45 and the irradiation window 80 of the electron beam irradiator mounted thereon.

Fig. 22 is another diagram illustrating in detail the measuring jig 45 and the irradiation window 80 of the electron beam irradiator mounted thereon.

Fig. 23 is a diagram illustrating a frequency characteristic of the irradiation window 80 of the membrane structure.

Fig. 24 is a diagram illustrating a method for allowable range based determination according to Embodiment 2 of the present invention.

Fig. 25 is a diagram illustrating another method for allowable range based determination according to Embodiment 2 of the present invention.

Fig. 26 is a diagram illustrating still another method for allowable range based determination according to Embodiment 2 of the present invention.

Fig. 27 is a diagram illustrating a case where the allowable range based determination of an output sound pressure is made with thresholds being changed within a given frequency band.

Fig. 28 is a diagram illustrating a case where the allowable range based determination of the output sound pressure is made on the basis of an area ratio.

Fig. 29 is a diagram illustrating a case where the allowable range based determination of the output sound wave is made with the use of a resonance point of the device.

### EXPLANATION OF LETTERS OR NUMERALS

1, 1#: Inspection system, 2: Speaker, 3: MIC, 4, P: Probe, 5: Tester, 6: Probe card, 10: Substrate, 15: Input/output interface, 20: Control part, 25: Measurement part, 30: Speaker control part, 31: Voltage drive part, 35: Signal adjustment part, 45: Measuring jig.

### DETAILED DESCRIPTION OF THE INVENTION

Embodiments of the present invention will hereinafter be described in detail with reference to the drawings. Note that the same symbols are used for the same or equivalent portions in the drawings, and a description of any duplicated portion is not repeated.

### (Embodiment 1)

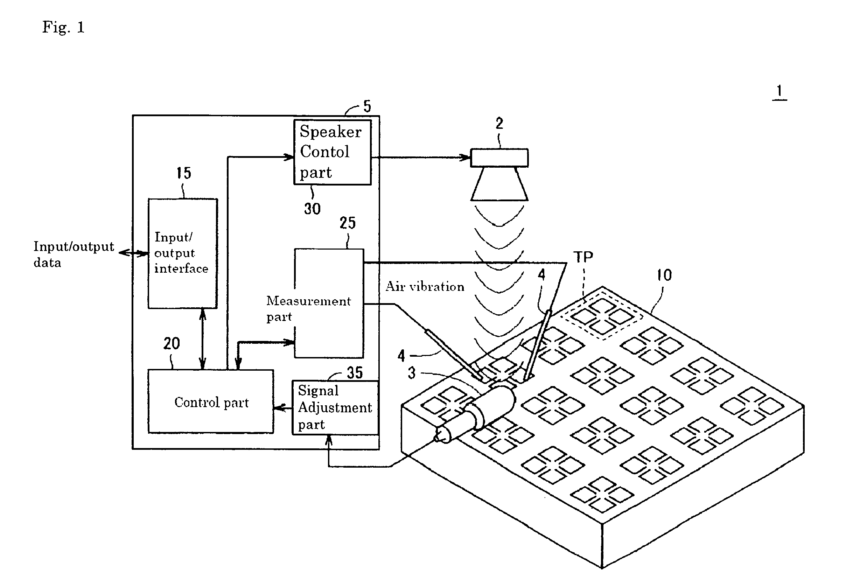

Fig. 1 is a schematic configuration diagram of a minute structure inspection system 1 according to Embodiment 1 of the present invention.

Referring to Fig. 1, the inspection system 1 according to Embodiment 1 of the present invention comprises a tester (inspection device) 5, and a substrate 10 formed thereon with a plurality of minute structure chips TP each having a minute movable portion.

In this embodiment, a triaxial acceleration sensor, which is one of multiaxial sensors, is described as an example of a minute structure to be tested.

The tester 5 comprises: a speaker 2 for outputting a sound wave, which is a compressional wave; input/output interface 15 for communicating input/output data between the outside and inside of the tester; control part 20 for controlling the entire tester 5; probes 4 used for contact with a test object; measurement part 25 for detecting via the probes 4 a measurement value of the test object to evaluate its characteristic; speaker control part 30 for controlling the speaker 2 in response to an instruction from the control part 20; microphone (MIC) 3 for detecting external sound; and signal adjustment part 35 for converting a sound wave detected by the MIC 3 into a voltage signal, then amplifying the signal, and outputting the amplified signal to the control part 20. Note that the MIC 3 can be arranged near the test object.

Before describing an inspection method according to this embodiment, the minute structure triaxial acceleration sensor, which is the test object, is first described.

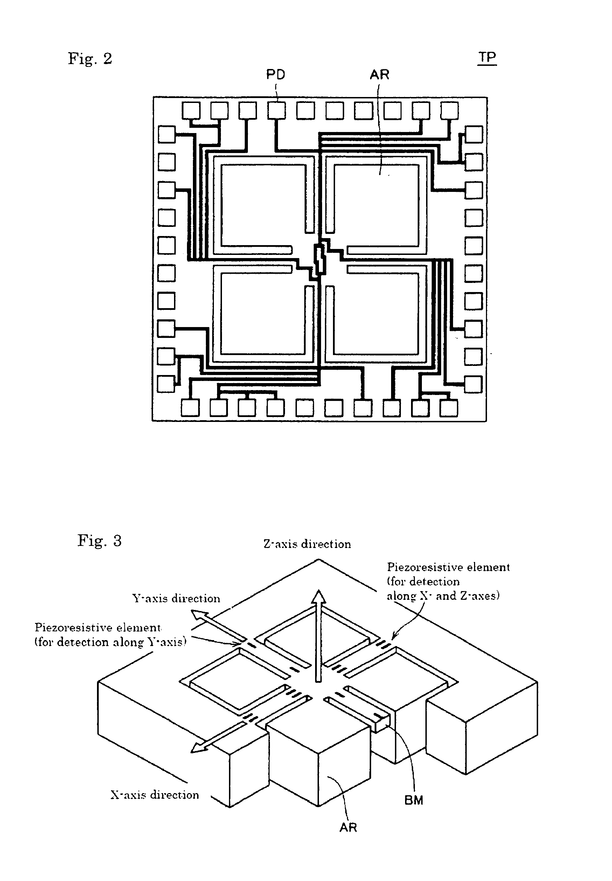

Fig. 2 is a diagram of the triaxial acceleration sensor as viewed from above the device.
As illustrated in Fig. 2, a plurality of electrode pads PD are arranged near the circumference of the chip TP formed on the substrate 10. Also, metal wiring is provided to transmit an electrical signal to/from the electrode pads. Further, in the center of the chip TP, four weights AR forming into a cloverleaf structure are arranged.

Fig. 3 is a schematic diagram of the triaxial acceleration sensor.
Referring to Fig. 3, the triaxial acceleration sensor is provided with piezoresistive elements, which are of a piezoresistive type and detecting elements, as diffusion resistance. The acceleration sensor of the piezoresistive type can utilize low cost IC processing, and exhibits no reduction in sensitivity even if the resistive element, which is the detecting element, is formed small, so that the sensor has advantages in miniaturization and cost reduction.

As a specific configuration, the weights AR in the center are configured to be supported by four beams BM. Two pairs of the beams BM are respectively formed so as to be orthogonal to each other in two axial directions, i.e., X and Y directions, and four of the piezoresistive elements are provided for each of the axes. The four piezoresistive elements for Z-axis directional detection are arranged beside the piezoresistive elements for X-axis directional detection. The weights AR form into a top surface of the cloverleaf type in shape, and are connected to the beams BM in the center. By employing the cloverleaf structure, the weights AR can be made larger, and a length of the beams can be made longer, so that a high sensitive acceleration sensor can be provided even if it is small.

An operating principle of the triaxial acceleration sensor of the piezoresistive type is based on a mechanism in which, when the weights experience acceleration (inertial force), the beams BM are deformed, leading to changes of resistance values of the piezoresistive elements formed on surfaces of the beams BM, and the acceleration is detected on the basis of the changes. Also, it is configured such that outputs of the sensor are drawn from outputs of the after-mentioned Wheatstone bridges independently incorporated for the respective three axes.

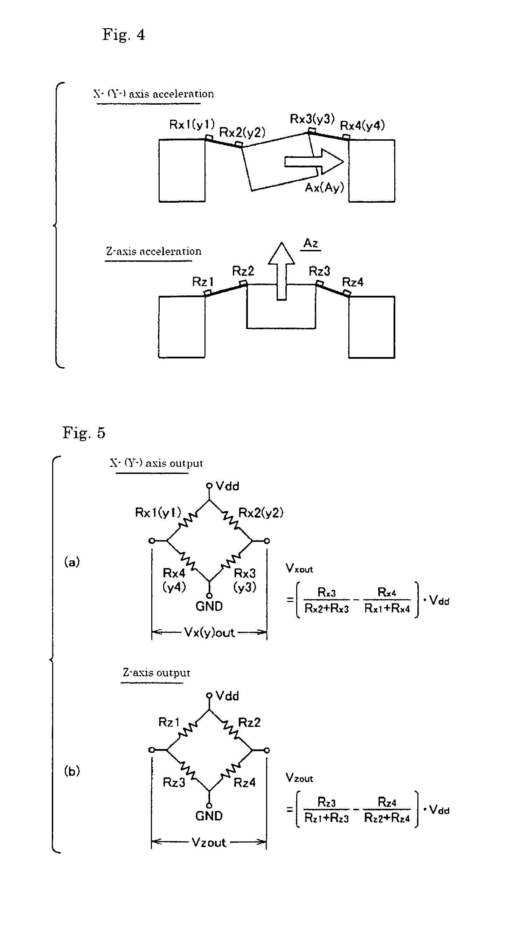

Fig. 4 is a conceptual diagram illustrating the weights and the deformations of the beams for the case of experience of the acceleration in each of the axial directions.

As illustrated in Fig. 4, the piezoresistive element is characterized by a change in resistance value due to applied deformation (piezoresistive effect), and the resistance value increases and decreases for tensile and compression deformations, respectively. In the diagram, the piezoresistive elements for X-axis directional detection Rx1 to Rx4, those for Y-axis directional detection Ry1 to Ry4, and those for Z-axis directional detection Rz1 to Rz4 are illustrated as an example.

Fig. 5 is a circuit configuration diagram of the Wheatstone bridge provided for each of the axes.
Fig. 5 (a) is a circuit configuration diagram of the Wheatstone bridge for the X (Y) axis. Output voltages for the X- and Y-axes are represented by Vxout and Vyout, respectively.

Fig. 5 (b) is a circuit configuration diagram of the Wheatstone bridge for the Z-axis. An output voltage for the Z-axis is represented by Vzout.

As described above, the resistance values of the four piezoresistive elements for each of the axes are changed due to the applied deformation, and on the basis of the changes, an output of a circuit formed with the Wheatstone bridge substantially consisting of the four piezoresistive elements, i.e., each axial component of the acceleration is detected as the independently separated output voltage, for example, for the X- or Y-axis. In addition, it is configured such that the above-describe metal wiring lines and the like as illustrated in Fig. 2 are connected to one another to form the above circuit, and the output voltage for each of the axes is detected via predetermined electrode pads.

Also, the triaxial acceleration sensor can detect a DC component of the acceleration, and therefore can also be used as a tilt angle sensor that detects gravitational acceleration

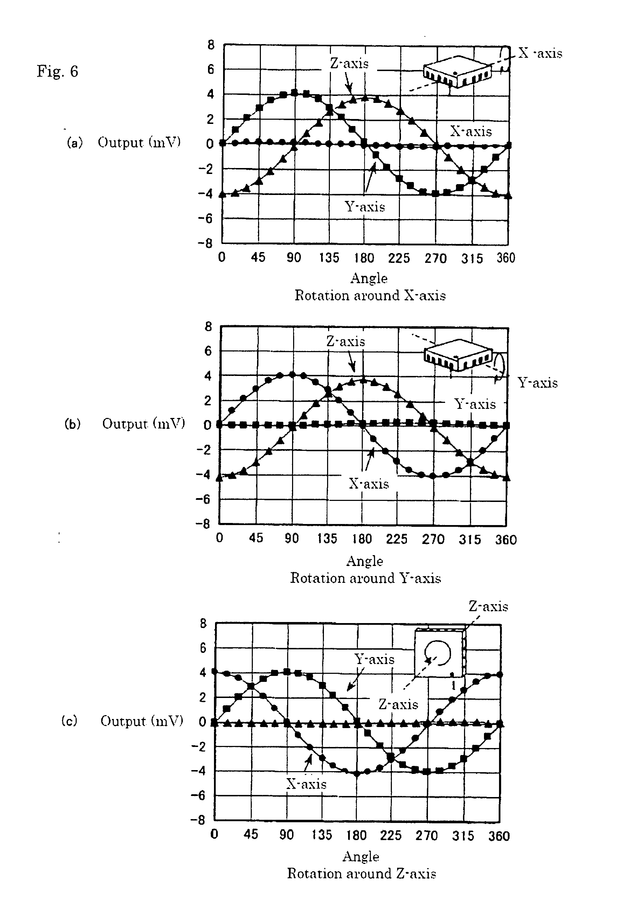

Fig. 6 is a diagram illustrating output response of the triaxial acceleration sensor versus a tilt angle.
Fig. 6 illustrates that the sensor is rotated around the X-, Y and Z-axes, and the bridge output for each of the X-, Y and Z-axes is measured with a digital voltmeter. As a power supply for the sensor, a low voltage power supply (+5V) is used. Note that at each measurement point illustrated in Fig. 6, an output value for each of the axes, from which a zero point offset is arithmetically subtracted, is plotted.

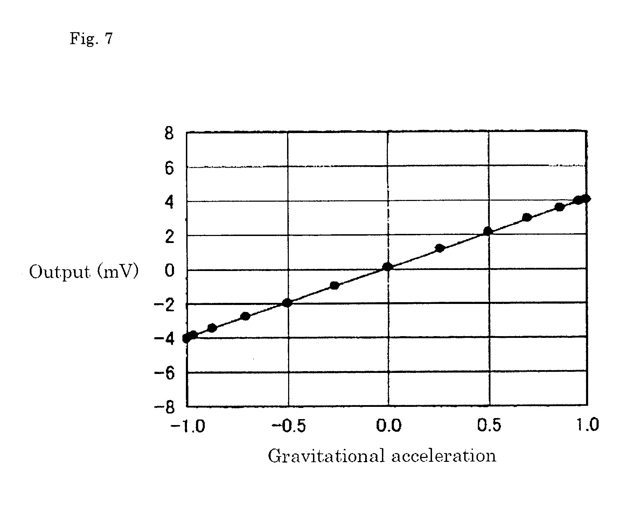

Fig. 7 is a diagram illustrating a relationship between the gravitational acceleration (input) and the sensor output.
The input/output relationship illustrated in Fig. 7 represents an evaluation result of linearity between the gravitational acceleration (input) and the sensor output, which is evaluated by calculating X-, Y- , and Z-axis components of the gravitational acceleration from a cosine of the tilt angle illustrated in Fig. 6, and obtaining the input/output relationship. That is, the relationship between the acceleration and the output voltage is approximately linear.

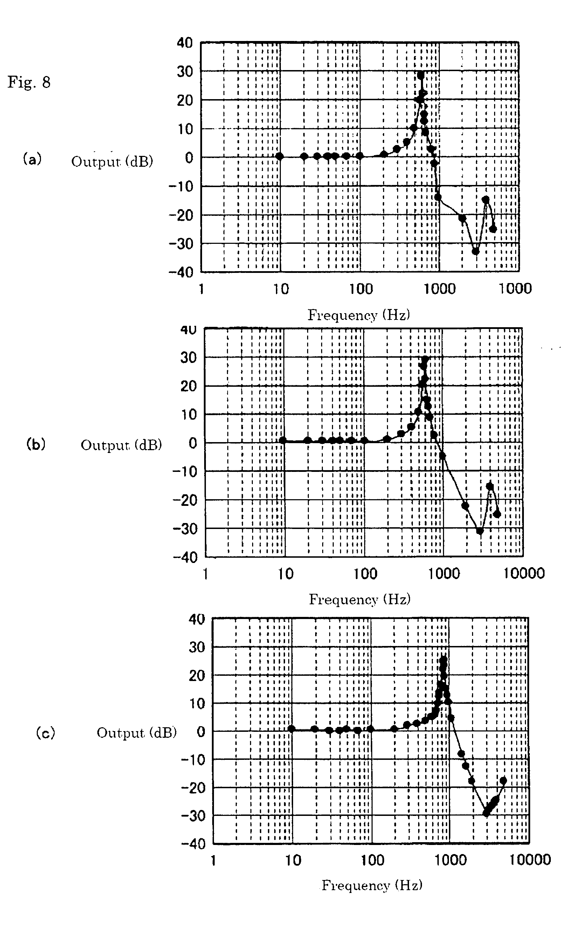

Fig. 8 is a diagram illustrating frequency characteristics of the triaxial acceleration sensor.
As illustrated in Fig. 8, the frequency characteristics of the sensor outputs for the respective X-, Y-, and Z-axes appear to be flat up to around 200 Hz for all of the three axes, and exhibit resonances at 602 Hz for the X-axis, 600Hz for the Y-axis, and 883 Hz for the Z-axis, as an example.

Referring again to Fig. 1, the minute structure inspection method according to the embodiment of the present invention is one in which a sound wave, which is a compressional wave, is outputted to the minute structure triaxial acceleration sensor, and movement of the movable portion of the minute structure based on the sound wave is detected to evaluate characteristics of the minute structure.

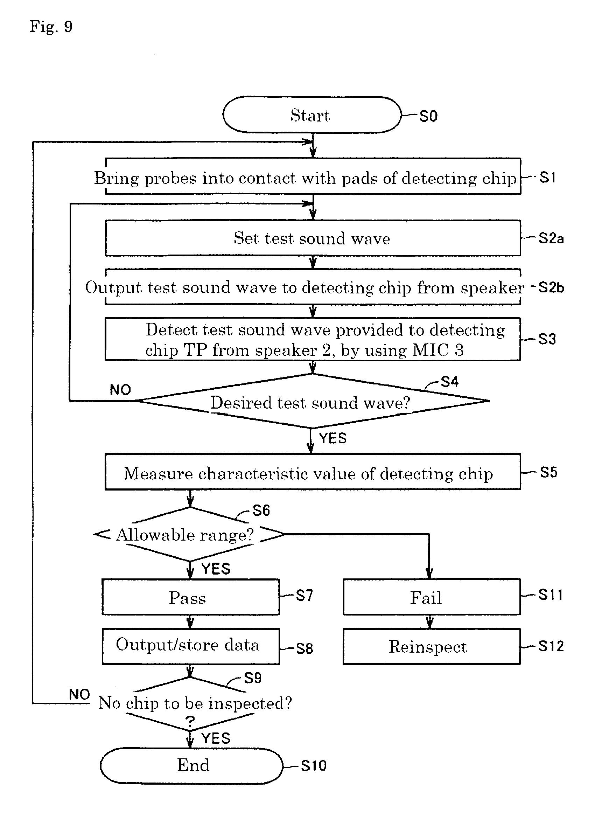

The minute structure inspection method according to Embodiment 1 of the present invention is described with the use of a flowchart illustrated in Fig. 9.

Referring to Fig. 9, first, the inspection (test) of the minute structure is started (Step S0). Then, the probes 4 are brought into contact with the electrode pads PD of the detecting chip TP (Step S1). Specifically, the probes 4 are brought into contact with the predetermined electrode pads PD to detect the output voltage of the Wheatstone bridge circuit illustrated in Fig. 5. Note that Fig. 1 illustrates the configuration employing the pair of probes 4; however, another configuration employing a plurality of pairs of probes is also applicable. Employing the plurality of pairs of probes enables output signals to be detected in parallel.

Then, a test sound wave to be outputted from the speaker 2 is set (Step S2a). Specifically, the control part 20 receives the input of input data from outside via the input/output interface 15. Subsequently, the control part 20 controls the speaker control part 30, and on the basis of the input data, instructs the speaker control part 30 to output the test sound wave having a desired frequency and sound pressure from the speaker 2. After that, the test sound wave is outputted to the detecting chip TP from the speaker 2 (Step S2b).

Subsequently, the MIC 3 is used to detect the test sound wave provided to the detecting chip TP from the speaker 2 (Step S3). The test sound wave detected by the MIC 3 is converted into a voltage signal followed by amplification in the signal adjustment part 35, and then outputted to the control part 20.

Subsequently, the control part 20 analyzes the voltage signal inputted from the signal adjustment part 35, and determines whether or not the desired test sound wave has reached (Step S4).

In Step S4, if the control part 20 determines that the desired test sound wave has reached, the flow proceeds to the next Step S5, where a characteristic value of the detecting chip is measured. Specifically, the characteristic value is measured in the measurement part 25 on the basis of an electrical signal transmitted via the probes 4 (Step S5).

Specifically, the movable portion of the minute structure of the detecting chip is moved upon receipt of the test sound wave that is outputted from the speaker 2 and the compressional wave, i.e., it is moved by air vibration. A change of the resistance value of the triaxial acceleration sensor, which is the minute structure being changed in structure on the basis of the movement, can be measured on the basis of the output voltage provided via the probes 4.

On the other hand, in Step S4, if the control part 20 determines that the test sound wave having reached is not desired, the flow returns to Step S2, where the test sound wave is reset. In such a case, the control part 20 instructs the speaker control part 30 to correct the test sound wave. The speaker control part 30 fine-adjusts a frequency and/or sound pressure in response to the instruction from the control part 20 so as to bring it to the desired test sound wave, and then controls the speaker 2 to output the desired test sound wave. Note that this embodiment describes a method in which the test sound wave is detected and corrected to come to the desired test sound wave; however, if the desired test sound wave preliminarily reaches the minute structure of the detecting chip, it may be configured such that the correcting means for the test sound wave and the method for correcting the test sound wave are not particularly provided. Specifically, the processing from Step S2a to S4 is preliminarily performed prior to the test start, and a corrected control value for outputting the desired test sound wave is stored in the speaker control part 30. Then, when the minute structure is actually tested, the speaker control part 30 may control the input to the speaker 2 with the stored control value to thereby omit the processing in Steps S3 and S4.

Subsequently, the control part 20 determines whether or not the measured characteristic value, i.e., measured data is within an allowable range (Step S6). If it is determined in Step S6 that the data is within the allowable range, the data is considered as "Pass" (Step S7), and then outputted and stored (Step S8). After that, the flow proceeds to Step S9. In this embodiment, the control part 20 determines as the allowable range based determination whether or not the chip has appropriate characteristics by detecting the frequency response characteristics of the triaxial acceleration sensor caused by the input of the test sound wave outputted from the speaker 2. In addition, regarding the storage of the data, the data is supposed to be stored in a storage part such as a memory provided inside the tester 5, on the basis of an instruction from the control part 20, although such a procedure is not illustrated here.

In Step S9, if there remains no chip to be inspected, the inspection (test) of the minute structure is ended (Step S10).

On the other hand, in Step S9, if there still remains any chip to be inspected, the flow returns to the first Step S1, from which the above-described inspection is performed.

In Step S6, if the control part 20 determines that the measured characteristics value, i.e., the measured data is outside the allowable range, the data is considered as "Fail" (Step S11), and then reinspected (Step S12). Specifically, the chips determined by the reinspection to be outside the allowable range can be removed. Alternatively, even if the chips are determined to be outside the allowable range, they may be grouped into a plurality of groups. That is, even if the chips cannot clear a severe test condition, many of the chips may be delivered without any problem by being repaired/corrected, or by other means. Accordingly, the grouping is performed through the reinspection or the like to thereby screen the chips, and some of the chips may be delivered on the basis of a result of the screening.

Note that this embodiment describes, as an example, the configuration in which the change in resistance value of the piezoresistive element provided in the triaxial acceleration sensor in response to the movement of the triaxial acceleration sensor is detected from the output voltage to make the determination; however, it may be configured such that, without limitation to the resistive element, a change in impedance value of a capacitive element, reactance element, or the like, or a change in voltage, current, frequency, phase difference, delay time, position, or the like based on the change in impedance value is detected to make the determination.

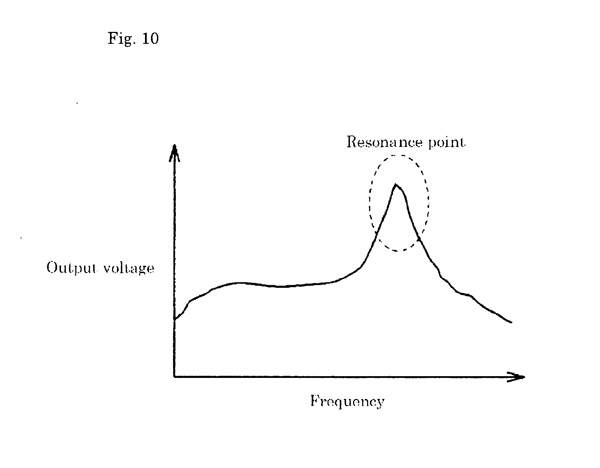

Fig. 10 is a diagram illustrating the frequency response of the triaxial acceleration sensor in response to the test sound wave outputted from the speaker 2.

Fig. 10 illustrates the output voltage outputted from the triaxial acceleration sensor under the condition that the test sound wave having a sound pressure of 1 Pa (Pascal) is provided and an associated frequency is varied. The vertical axis represents the output voltage (mV) of the triaxial acceleration sensor, and the horizontal axis the frequency (Hz) of the test sound wave.

In this diagram, the output voltage obtained for the X-axis direction is illustrated. In this example, the frequency characteristic only for the X-axis is illustrated; however, similar frequency characteristics can be obtained for the Y and Z-axes as well, so that the characteristic of the acceleration sensor can be evaluated for each of the three axes.

The allowable range based determination is described in detail here. For a device such as the triaxial acceleration sensor, a frequency band for the actual use of the device is predefined. Accordingly, it is necessary to check whether or not the response characteristic in a preliminarily assumed use condition or usage is within the allowable range. In particular, the device has a specific resonant frequency as illustrated in Fig. 10. Also, there exists a possibility that continuity in the response characteristic of the device is not ensured due to a crack, damage, or the like. Accordingly, in order to perform the highly accurate inspection, it is necessary to determine that the response characteristic of the device is continuous, and the device exhibits a desired characteristic.

In this regard, the relationship between the frequency and the sensor output is nonlinear as illustrated in Fig. 10, and the frequency band for the use of the device has a certain width, so that a threshold may be provided to simply make the determination.

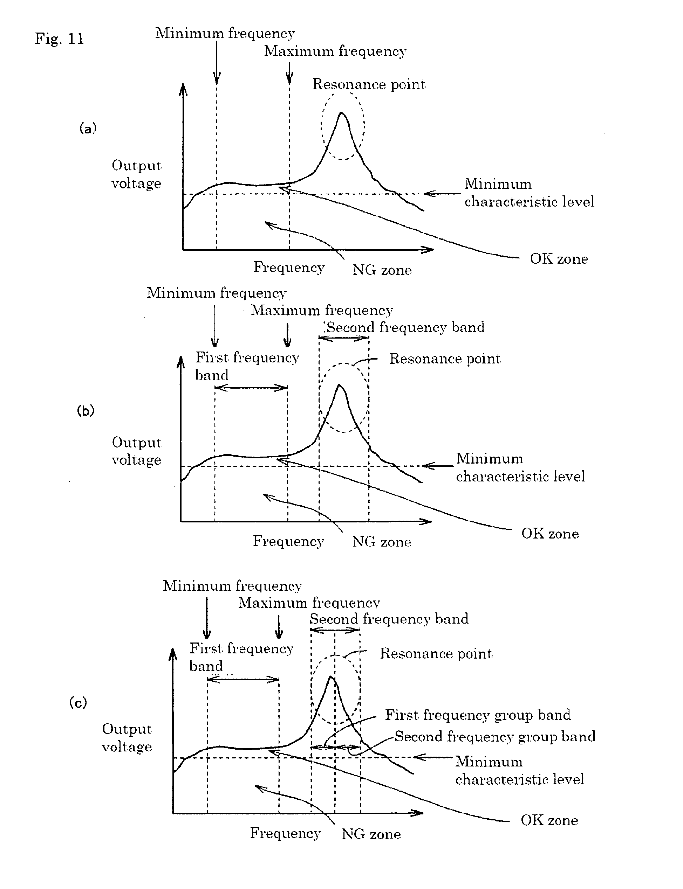

Fig. 11 is a diagram illustrating a method for allowable range based determination according to Embodiment 1 of the present invention.

Referring to Fig. 11 (a), here, maximum and minimum frequencies required for the device are calculated on the basis of the preliminarily assumed use condition or the like, and it is determined whether or not the desired characteristic can be detected within the resultant frequency band. In the diagram, a minimum characteristic level is illustrated as a lower limit level and a threshold, and in the example illustrated in Fig. 11, the response characteristic equal to or more than the threshold corresponding to the minimum characteristic level is detected within the given frequency band, so that the device can be determined to be a good item.

On the other hand, if it is less than the threshold, the device may be screened and forwarded as a defective item to processing such as the reinspection.

In addition, as a method for setting the threshold, there are various possible methods; however, the threshold may be set on the basis of the frequency response characteristics of the output voltages at a wafer level of products determined to be either the good item or defective item at a package (production) level following assembly from the wafer level. That is, the threshold may be appropriately set on the basis of a plurality of good and defective item samples, in consideration of their variations or the like. In this example, it is only determined whether or not the frequency characteristic is less than the given threshold level; however, without limitation to this, the frequency response characteristic of the output voltage of the good item may be used as the threshold on the basis of a simulation result of the frequency response characteristic of the output voltage of the good item, to make the determination between the good and defective items on the basis of whether or not a frequency response characteristic of the output voltage is approximate to that of the good item. Also, in order to improve accuracy, the determination between the good and defective items may be made in combination with a visual inspection.

As illustrated in Fig. 11 (b), the maximum and minimum frequencies required for the device may be set in advance on the basis of the preliminarily assumed use condition or the like, and it may be determined whether or not the desired characteristic can be detected within the first resultant frequency band, and also whether or not a preliminarily assumed resonant frequency is included within a given frequency band (second frequency band) to thereby make a highly accurate determination between the good and defective items. Also, in the diagram, a method in which the two frequency bands are used to make the determination between the good and defective items is illustrated as an example; however, without limitation to this, by using a plurality of frequency bands more than 2, and providing thresholds for determination, it becomes possible to analyze the device characteristic in more detail, so that the determination between the good and defective items can be made with high accuracy. Further, as above, it is described that the maximum and minimum frequencies required for the device are set on the basis of the preliminarily assumed use condition or the like; however, it should be appreciated that, without limitation to this condition, the maximum and minimum frequencies may be set on the basis of another condition or another method.

As illustrated in Fig. 11 (c), for example, the given frequency band may be further divided into a plurality of frequency bands, as compared with Fig. 11 (b). In this example, the second frequency band may be divided into two groups, i.e., first and second frequency group bands, to determine which group within the given frequency band a preliminarily assumed resonant frequency belongs to. This diagram illustrates a case where the resonant frequency is included in the first frequency group band. This enables, for example, the good items to be classified in performance by the grouping even in a case where the devices are determined to be the good items.

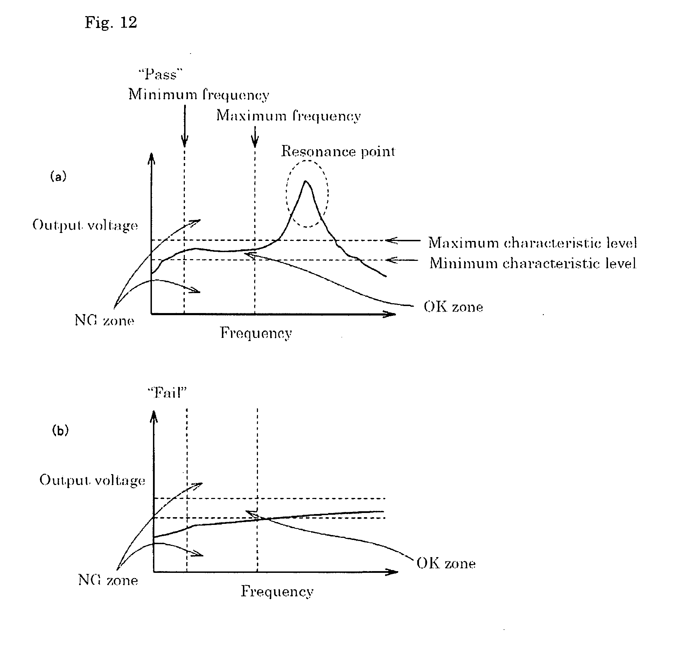

Fig. 12 is a diagram illustrating another method for allowable range based determination according to Embodiment 1 of the present invention.

Fig. 12 (a) illustrates a frequency characteristic for a case of a good item. In this diagram, a maximum characteristic level is illustrated as an upper limit level and a threshold, in addition to the minimum characteristic level described with the determination method illustrated in Fig. 11. For example, the device having a characteristic ranging from the minimum characteristic level to the maximum characteristic level, both inclusive, within the given frequency band is determined to be the good item. In this example, the device can be determined to be the good item (Pass).

Fig. 12 (b) illustrates a frequency characteristic for a case of a defective item. According to the above determination method, an output less than the minimum characteristic level within the given frequency band is only obtained, so that the device can be determined to be the defective item (Fail).

In addition, even if the characteristic meets the threshold corresponding to the minimum characteristic level, the response characteristic may be steeply changed around a resonant frequency if a resonance point is included within the given frequency band, for example. That is, sensitivity of the sensor abnormally increases. In such a case, it becomes difficult to accurately measure and output an appropriate value as the acceleration sensor. Accordingly, by providing the threshold corresponding to the maximum characteristic level on the basis of this determination method, it becomes possible to screen out such defective item and only select the good item as the allowable range based determination.

In addition, regarding the thresholds corresponding to the minimum and maximum characteristic levels, as described above, the thresholds corresponding to the upper and lower limits can be set for the frequency response characteristic of the output voltage on the basis of a plurality of good and defective item samples, in consideration of their variations.

Also, as an alternative method, the classification in performance may be performed by providing a plurality of characteristic level more than 2, and determining which region includes the response characteristic.

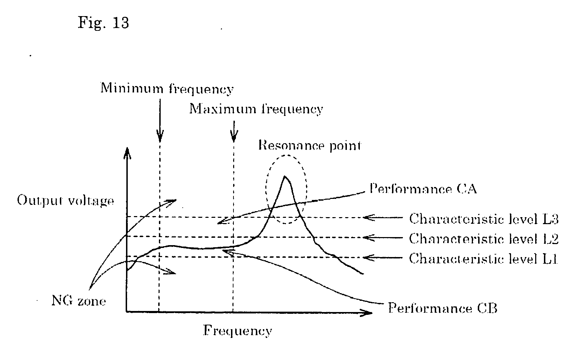

Fig. 13 is a diagram illustrating still another method for allowable range based determination according to Embodiment 1 of the present invention. In the diagram, a plurality of characteristic levels L1 to L3 are provided.

For example, if the output characteristic is detected in a region sandwiched between the characteristic levels L1 and L2, device performance is defined as "Performance CB". On the other hand, if the output characteristic is detected in a region sandwiched between the characteristic levels L2 and L3, the device performance is defined as "Performance CA".

Based on such classification, for example, the devices included in the Performance CB category may be treated as those having normal sensitivity, whereas the devices included in the Performance CA category may be classified as those having too much sensitivity.

Also, as another determination method, the determination may be made with thresholds being changed within a given frequency band.

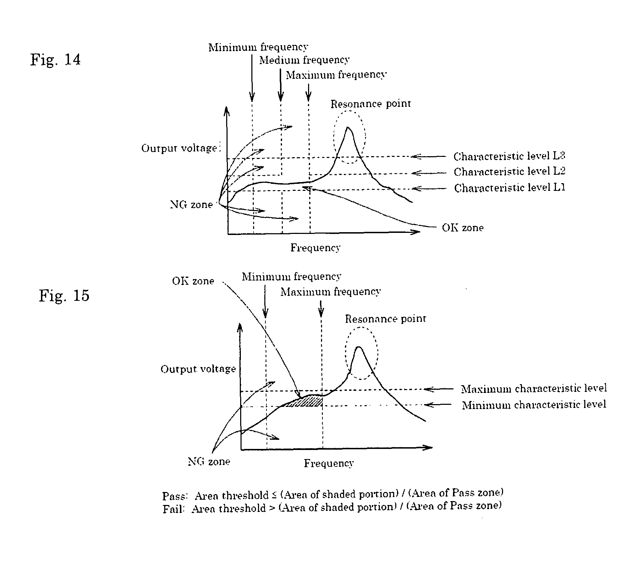

Fig. 14 is a diagram illustrating a case where the allowable range based determination of the sensor output voltage is made with the thresholds being changed within the given frequency band.

As illustrated in Fig. 14, a plurality of characteristic levels L1 to L3 are provided. Then, it is determined whether or not the response characteristic appears in a region sandwiched between the characteristic levels L1 and L2 within a range from a minimum frequency to a medium frequency. Subsequently, it may be determined whether or not the response characteristic appears in a region sandwiched between the characteristic levels L1 and L3 within a range from the medium frequency to a maximum frequency.

As described, by further breaking the condition into smaller ones, it becomes possible to make the determination with higher accuracy.

Also, as still another determination method, there may be a method comprising: calculating the maximum and minimum frequencies required for the device on the basis of the preliminarily assumed use condition or the like; calculating a ratio of an area occupying within a frequency band sandwiched between them, and determining whether or not the response characteristic is within the allowable range, on the basis of whether or not the area ratio exceeds a given reference area ratio.

Fig. 15 is a diagram illustrating a case where the allowable range based determination of the sensor output voltage is made on the basis of the area ratio.

As illustrated in Fig. 15, an area of a region surrounded between minimum and maximum frequencies and also between minimum and maximum characteristic levels is made a reference. Then, an area occupied by the response characteristic of the device in this region is calculated. Subsequently, the area ratio is calculated. In this example, it is determined whether or not (an area of a shaded portion / an area of an OK (Pass) zone) is equal to or more than the given reference area ratio, i.e., an area threshold. If it is equal to or more than the area threshold, the device is determined to be "Pass", whereas if it is less than the area threshold, the device is determined to be "Fail".

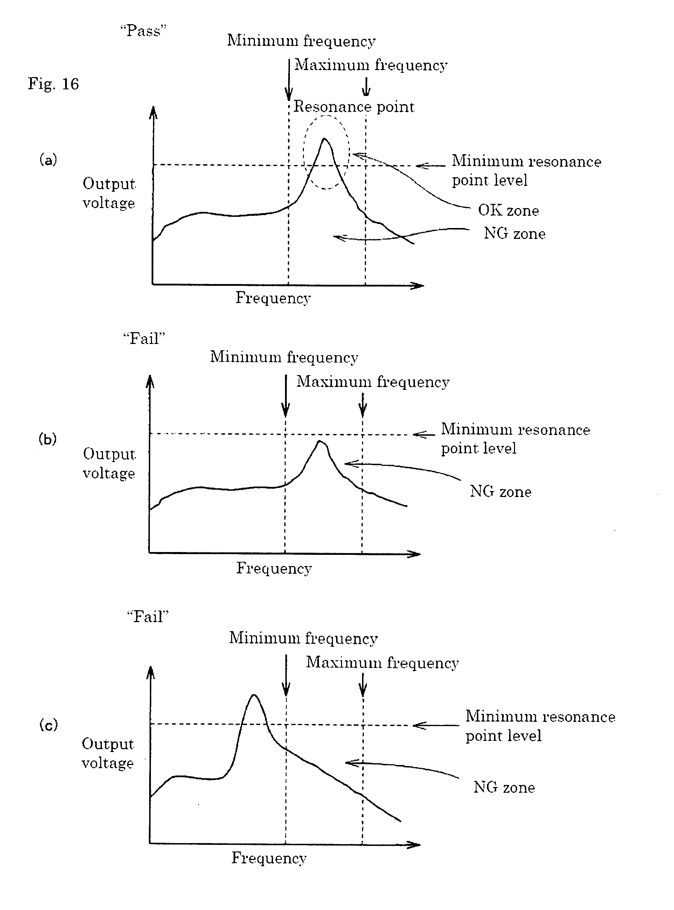

Also, as yet another determination method, the determination may be made with the use of a resonance point. Fig. 16 is a diagram illustrating a case where the allowable range based determination of the sensor output voltage is made with the use of the resonance point of the device.

As illustrated in Fig. 16 (a), it is determined whether or not the resonance point exceeds a minimum resonance point level in a given frequency band between minimum and maximum frequencies. If it exceeds the minimum resonance point level, the device is determined to be "Pass".

On the other hand, as illustrated in Fig. 16 (b), if it does not exceed the minimum resonance point level, the device is determined to be "Fail".

Further, as illustrated in Fig. 16 (c), if there is no resonance point in the given frequency band between the minimum and maximum frequencies, the device is also determined to be "Fail".

As described above, based on the method for determining the minute structure according to Embodiment 1, it can be easily determined whether or not the device is within the allowable range, and the devices can be easily classified. Note that the above description gives various examples of the method for determining the minute structure; however, it should be appreciated that, without limitation to these examples, for example, the determination may be made in combination of them.

Also, in the configuration according to the above embodiment, the speaker control part 30 outputs from the speaker the test sound wave, which is a sine wave having a single frequency; however, without limitation to this, for example, an unshown adder or the like may be used to synthesize a plurality of sine wave signals having different frequencies, followed by output of the synthesized signal from the speaker. This enables responses to the plurality of frequencies to be detected at once, so that the frequency response characteristic as illustrated in Fig. 10 can be efficiently and effectively checked. Also, the test sound wave outputted from the speaker is not limited to the sine wave signal or the synthesis of sine wave signals, but the test sound wave having any waveform like white noise may be outputted with the use of an unshown function generator (arbitrary waveform generator). This enables, for example, the minute structure to be simply inspected in terms of its resonant frequency and associated vibrational characteristic because the white noise is sound including almost equal amounts of all frequency components. In such a case, the resonant characteristic of the minute structure may be efficiently and effectively inspected by limiting a frequency band of the test sound wave to a region near the resonant frequency of the minute structure with the use of, for example, a band-pass filter or the like.

### (Embodiment 2)

The above Embodiment 1 describes the method for determining whether or not the device is within the allowable range by inputting the test sound wave, and analyzing the frequency characteristic of the output result in response to the input.

Embodiment 2 of the present invention describes a method for determining whether or not a device is within an allowable range by analyzing a frequency characteristic corresponding to a result of sound output from the device itself.

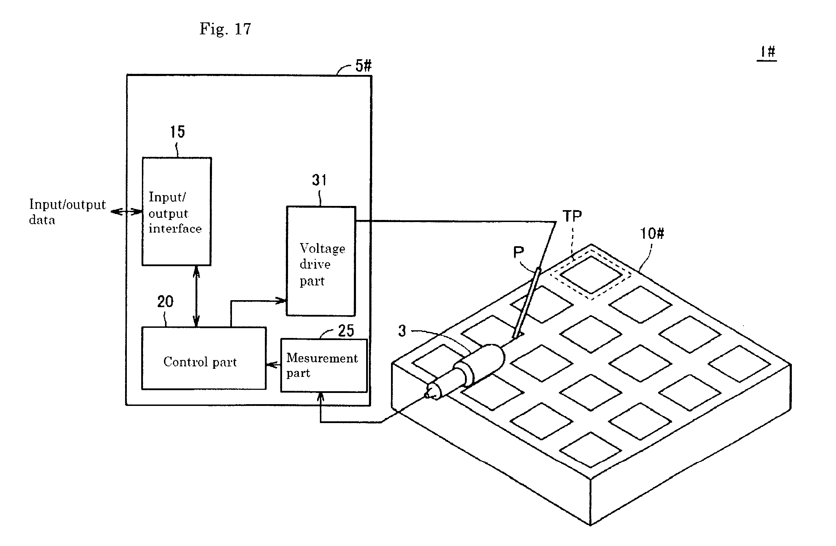

Fig. 17 is a schematic configuration diagram of a minute structure inspection system 1# according to Embodiment 2 of the present invention.

Referring to Fig. 17, the inspection system 1# according to this embodiment of the present invention comprises a tester (inspection device) 5# and a substrate 10# formed thereon with a plurality of minute structure chips TP each having a minute movable portion.

The tester 5# comprises: a MIC 3 for detecting sound outputted from the detecting chip TP; input/output interface 15 for communicating input/output data between the outside and inside of the tester; control part 20 for controlling the entire tester 5# and analyzing sound detected by a measurement part 25; measurement part 25 for measuring the sound detected by the MIC 3; and voltage drive part 31 for outputting voltage that is an electrical signal for providing movement to the movable portion of the chip TP. Note that the MIC 3 is supposed to be arranged near the test object. Also, in Fig. 17, a given voltage is supposed to be applied to an unshown pad of the chip TP from the voltage drive part 31 via a probe P. Note that this embodiment describes a case where the movable portion of the chip TP is moved by electrical action; however, without limitation to this, the movable portion of the chip TP may be moved by another means such as magnetic action.

Next, a case where the minute structure of a membrane structure is inspected as the detecting chip is described.

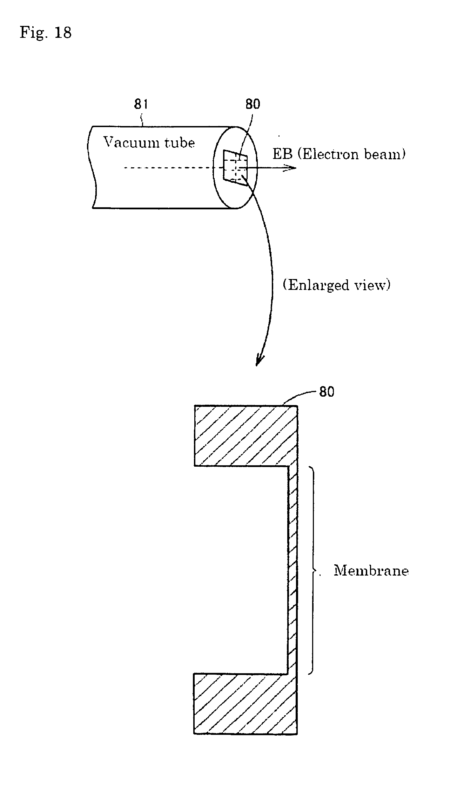

Fig.18 is a diagram illustrating a case where the membrane structure is used for an irradiation window of an electron beam irradiator.

As illustrated in Fig. 18, an electron beam EB is emitted to the atmosphere from a vacuum tube 81 of which an irradiation window 80 is partly illustrated, and the membrane structure of a thin film is employed as illustrated in an enlarged cross-sectional structure of the irradiation window 80. Note that in Fig. 18, the membrane is formed of a single material, and only one membrane structure is illustrated; however, the membrane having a multilayer film structure may be formed of a plurality of materials, or the irradiation window may be configured to have a plurality of membrane structures arranged in an array form.

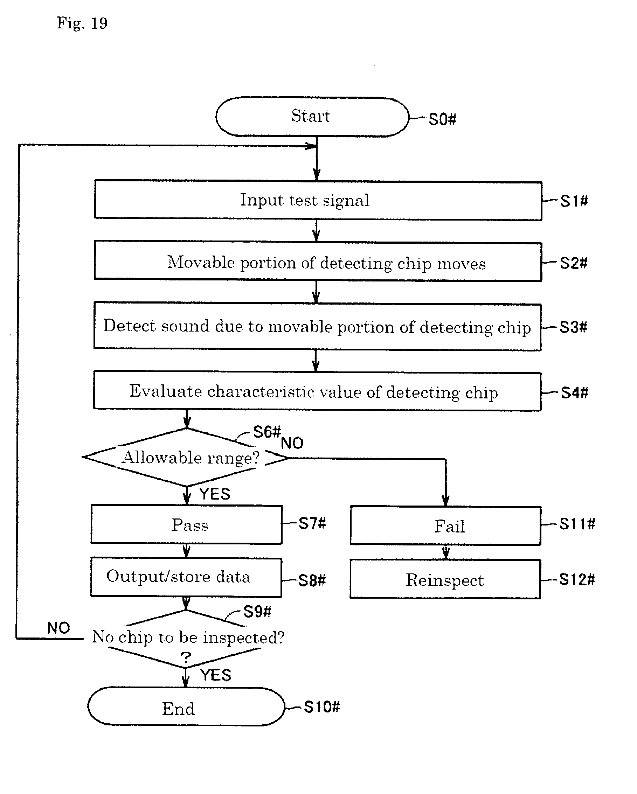

A method for inspecting the minute structure according to Embodiment 2 of the present invention is described with the use of a flowchart illustrated in Fig. 19.

Referring to Fig. 19, first, the inspection (test) of the minute structure is started (Step S0#). Then, a test signal is inputted to the test chip TP (Step S1#). Note that it is supposed that the test signal is inputted to the control part 20 via the input/output interface 15 on the basis of the input/output data inputted from outside, and the control part 20 instructs the voltage drive part 31 to output output-voltage corresponding to the given test signal.

As a result, the movable portion of the detecting chip TP is moved by the test signal (Step S2#). The specific movement of it is described later; however, applying the test signal allows the membrane to move up and down. Sound generated during the up and down movement is detected with the MIC 3. That is, the sound arising from the membrane corresponding to the movable portion of the detecting chip is detected (Step S3#).

Then, the control part 20 evaluates a characteristic value of the detecting chip based on the sound detected by the MIC 3 (Step S4#).

Subsequently, the control part 20 determines whether or not the measured characteristic value, i.e., measured data is within an allowable range (Step S6#). Specifically, a signal characteristic of the sound detected by the measurement part 25 is analyzed to determine whether or not the device is within an allowable range.

In Step S6#, if it is determined that the measured data is within the allowable range, the device is considered as "Pass" (Step S7#), and the data is outputted and stored (Step S8#). Note that the storage of the data is not illustrated here; however, the data is supposed to be stored in a storage part such as a memory provided inside the tester 5#, on the basis of an instruction from the control part 20. The control part 20 also plays a role as a determination part for determining the detecting chip on the basis of the measured data from the measurement part 25.

In Step S9#, if there remains no chip to be inspected, the inspection (test) of the minute structure is ended (Step S10#). On the other hand, if there remains any chip to be inspected, the flow returns to the first Step S1# from which the above-described inspection is performed.

In Step S6#, if the control part 20 determines that the measured characteristic value, i.e., the measured data is outside the allowable range, the device is considered as "Fail" (Step S11#), and then reinspected (Step S12#). Specifically, the chips determined to be outside the allowable range can be removed on the basis of the reinspection. Alternatively, even the chips determined to be outside the allowable range may be grouped into a plurality of groups. That is, even if the chips cannot clear a severe test condition, many of the chips may be delivered without any problem by being repaired/corrected, or by other means. Accordingly, the grouping through the reinspection or the like is performed to thereby screen the chips, and some of the chips may be delivered on the basis of a result of the screening.

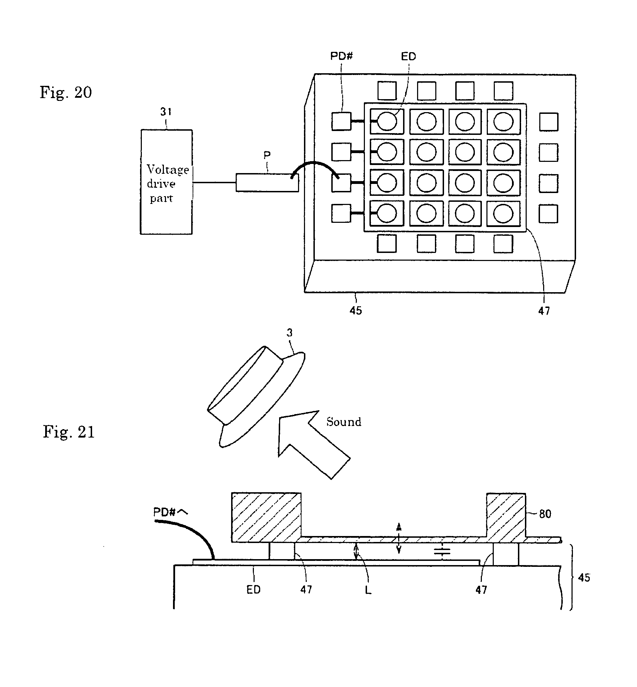

Fig. 20 is a conceptual diagram illustrating a part of the minute structure inspection system 1# according to Embodiment 2 of the present invention.

Referring to Fig. 20, a measuring jig 45 is provided in this case. Also, the voltage drive part 31 of the tester 5# is electrically connected to a pad PD# of the measuring jig 45 via the probe P.

The diagram illustrates, as an example, a case where one of the pads PD# and the probe P are electrically connected to each other. Also, a spacer 47 is provided on a surface of the measuring jig 45 such that electrodes ED and the irradiation window 80 are not brought into direct contact with each other.

Fig. 21 is a diagram illustrating in detail the measuring jig 45 and the irradiation window 80 of the electron beam irradiator mounted thereon.

Referring to Fig. 21, the electrodes ED are provided on the surface of the measuring jig 45. Also, the spacer 47 for ensuring a given interval between the electrodes ED and the irradiation window 80 is provided. Further, the electrode ED and the external pad PD# are electrically connected to each other as described above.

The inspection method is performed according to a method similar to that described with Fig. 19. That is, by applying the voltage from the voltage drive part 31 via the probe P, the membrane is sucked by the measuring jig 45 on the basis of electrostatic attraction force between the membrane and the electrode ED, and the detecting sound outputted from the device having the membrane structure by the suction action being periodically performed is detected with the MIC 3. Then, the detected sound is measured in the measurement part 25, and the measured sound is determined in the control part 20.

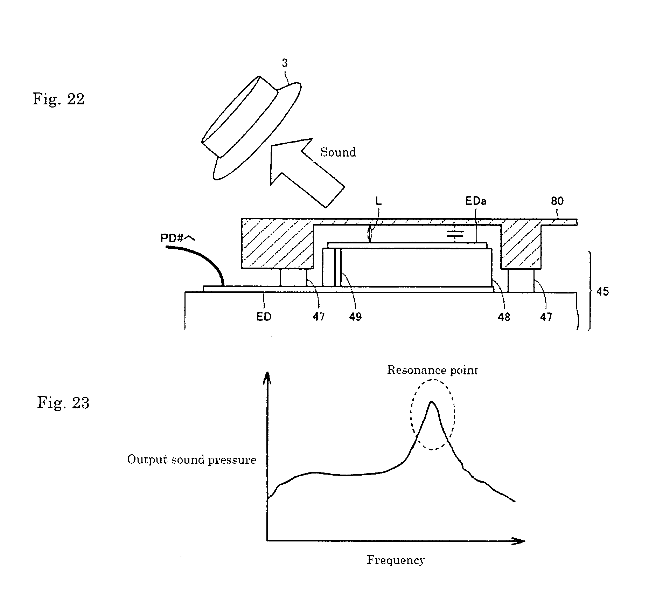

Fig. 22 is another diagram illustrating in detail the measuring jig 45 and the irradiation window 80 of the electron beam irradiator mounted thereon.

Referring to Fig. 22, a different point as compared with the irradiation window 80 illustrated in Fig. 21 is that the irradiation window 80 of the membrane structure illustrated in Fig. 21 is arranged so as to face downward, whereas that illustrated in Fig. 22 is arranged so as to face upward. Also, a spacer 48 and a sub electrode EDa are provided on the electrode ED, and the electrode ED and the sub electrode EDa are electrically connected to each other via a contact hole passing through the spacer 48. Further, as described with Fig. 21, a distance between the electrode, i.e., the sub electrode EDa in this case and the membrane structure is set to L. Even in this case, the minute structure can be inspected according to a method similar to that in the case of Fig. 20.

Fig. 23 is a diagram illustrating a frequency characteristic of the irradiation window 80 of the membrane structure.
As illustrated in Fig. 23, the horizontal axis represents a frequency (Hz), and the vertical axis an output sound pressure. Also, a determination method similar to the above-described one can be performed.

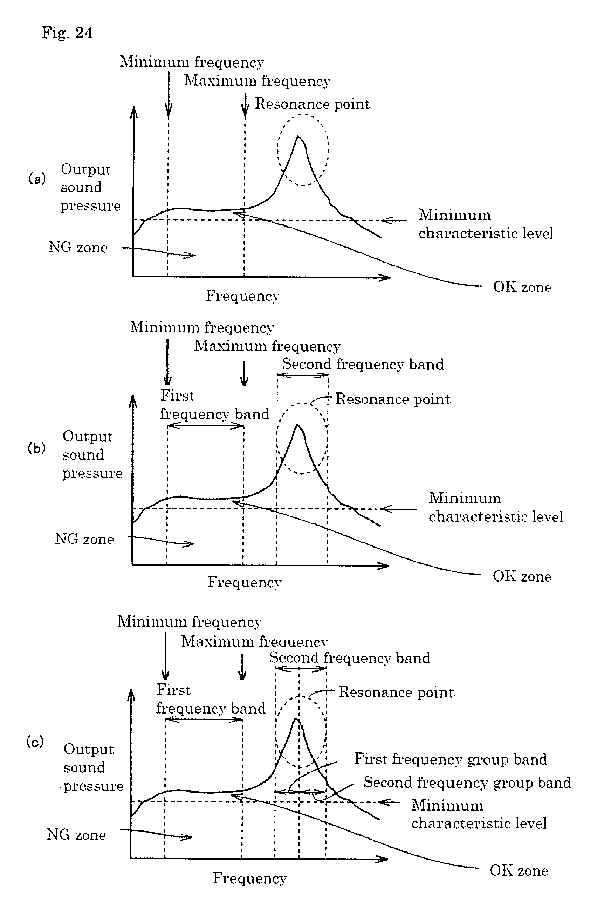

Fig. 24 is a diagram illustrating a method for allowable range based determination according to Embodiment 2 of the present invention. In this example, a case where the allowable range based determination is made on the basis of the frequency characteristic of the output sound pressure is described.

Referring to Fig. 24 (a), in this case, maximum and minimum frequencies required for the device are calculated on the basis of a preliminarily assumed use condition or the like, and it is determined whether or not a desired characteristic can be detected within the resultant frequency band. In the diagram, a minimum characteristic level is illustrated as a lower limit level and a threshold, and in the example illustrated in Fig. 24, the response characteristic equal to or more than the threshold corresponding to the minimum characteristic level is detected within the given frequency band, so that the device can be determined to be a good item.

On the other hand, if it is less than the threshold, the device may be screened and forwarded as a defective item to processing such as the reinspection.

In addition, as a method for setting the threshold, there are various possible methods; however, the threshold may be set on the basis of the frequency response characteristics of the output sound pressures at a wafer level of products determined to be either the good item or defective item at a package (production) level following assembly from the wafer level. That is, the threshold may be appropriately set on the basis of a plurality of good and defective item samples, in consideration of their variations or the like. Also, in this example, it is only determined whether or not the frequency response characteristic is less than the given threshold level; however, without limitation to this, the frequency response characteristic of the output sound pressure of the good item is used as the threshold on the basis of a simulation result of the frequency response characteristic of the output sound pressure of the good item, to make the determination between the good and defective items on the basis of whether or not the frequency response characteristic of the output sound pressure is approximate to that of the good item. Further, in order to improve accuracy, the determination between the good and defective items may be made in combination with a visual inspection.

As illustrated in Fig. 24 (b), the maximum and minimum frequencies required for the device may be set in advance on the basis of the preliminarily assumed use condition or the like, and it may be determined whether or not a desired characteristic can be detected within the resultant first frequency band, and also whether or not a preliminarily assumed resonant frequency is included within a given frequency band (second frequency band) to thereby make the determination between the good and defective items with high accuracy. Also, in the diagram, a method in which the two frequency bands are used to make the determination between the good and defective items is illustrated as an example; however, without limitation to this, by using a plurality of frequency bands more than 2, and providing thresholds for determination, it becomes possible to analyze the device characteristic in more detail, so that the determination between the good and defective items can be made with high accuracy. Further, as above, it is described that the maximum and minimum frequencies required for the device are set on the basis of the preliminarily assumed use condition or the like; however, it should be appreciated that, without limitation to this condition, the maximum and minimum frequencies may be set on the basis of another condition or another method.

As illustrated in Fig. 24 (c), for example, the given frequency band may be further divided into a plurality of frequency bands, as compared with Fig. 24 (b). In this example, the second frequency band may be divided into two groups, i.e., first and second frequency group bands, to determine which group within the given frequency band a preliminarily assumed resonant frequency belongs to. In this diagram, a case where the resonant frequency is included in the first frequency group band is illustrated. This enables, for example, the good items to be classified in performance by the grouping even in a case where the devices are simply determined to be the good items.

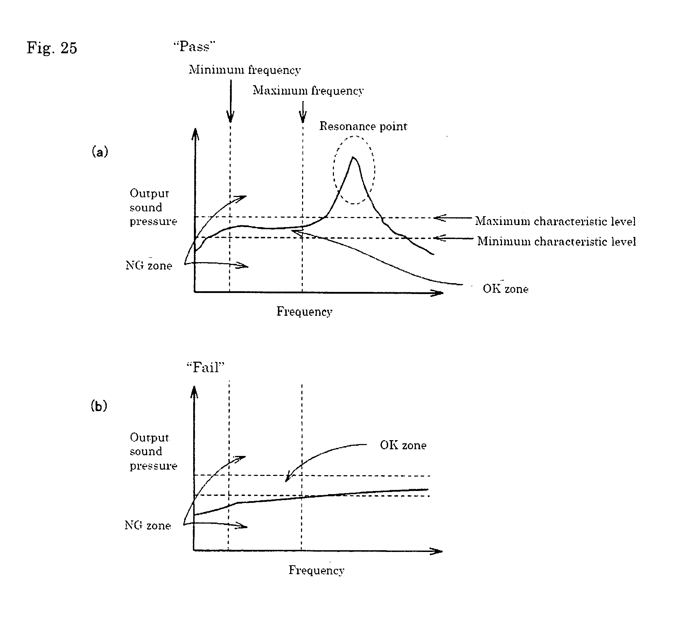

Fig. 25 is a diagram illustrating another method for allowable range based determination according to Embodiment 2 of the present invention.

Fig. 25 (a) illustrates a frequency characteristic for a case of a good item. In this diagram, a maximum characteristic level is illustrated as an upper limit level and a threshold, in addition to the minimum characteristic level described with the determination method illustrated in Fig. 24. For example, the device having a characteristic ranging from the minimum characteristic level to a maximum characteristic level, both inclusive, within the given frequency band is determined to be the good item. In this example, the device can be determined to be the good item (Pass).

Fig. 25 (b) illustrates a frequency characteristic for a case of a defective item. According to the above determination method, an output less than the minimum characteristic level within the given frequency band is only obtained, so that the device can be determined to be the defective item (Fail).

In addition, regarding the thresholds corresponding to the minimum and maximum characteristic levels, as described above, the thresholds corresponding to the upper and lower limits can be set for a frequency response characteristic of an output sound pressure on the basis of a plurality of good and defective item samples, in consideration of their variations.

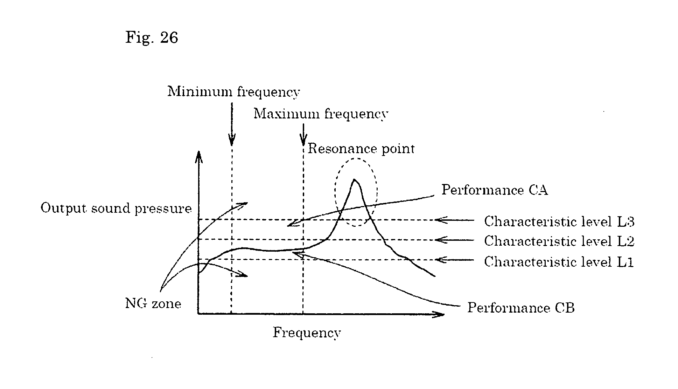

Fig. 26 is a diagram illustrating still another method for allowable range based determination according to Embodiment 2 of the present invention. In the diagram, a plurality of characteristic levels L1 to L3 are provided.

For example, if the output characteristic is detected in a region sandwiched between the characteristic levels L1 and L2, device performance is defines as "Performance CB". On the other hand, if the output characteristic is detected in a region sandwiched between the characteristic levels L2 and L3, the device performance is defined as "Performance CA".

Based on such classification, for example, the devices included in the Performance CB category may be treated as those having normal sensitivity, whereas the devices included in the Performance CA category may be classified as those having too much sensitivity.

Also, as another determination method, the determination may be made with thresholds being changed within a given frequency band.

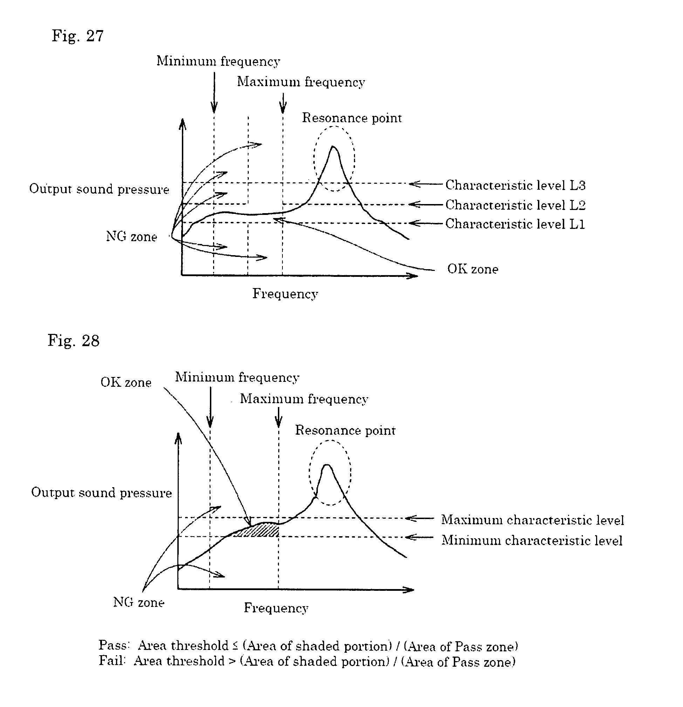

Fig. 27 is a diagram illustrating a case where the allowable range based determination of the output sound pressure is made with the thresholds being changed within the given frequency band.

As illustrated in Fig. 27, a plurality of characteristic levels L1 to L3 are provided. Then, it is determined whether or not the response characteristic appears in a region sandwiched between the characteristic levels L1 and L2 in a range from a minimum frequency to a medium frequency. Subsequently, it may be determined whether or not the response characteristic appears in a region sandwiched between the characteristic levels L1 and L3 within a range from the medium frequency to a maximum frequency.

As described, by further breaking the condition into smaller ones, it becomes possible to make the determination with higher accuracy.

Also, as still another determination method, there may be a method comprising: calculating the maximum and minimum frequencies required for the device on the basis of the preliminarily assumed use condition or the like; calculating a ratio of an area occupying within a frequency band sandwiched between them, and determining whether or not the response characteristic is within the allowable range, on the basis of whether or not the area ratio exceeds a given reference area ratio.

Fig. 28 is a diagram illustrating a case where the allowable range based determination of the output sound pressure is made on the basis of the area ratio.

As illustrated in Fig. 28, an area of a region surrounded between minimum and maximum frequencies and also between minimum and maximum characteristic levels is made a reference. Then, an area occupied by the response characteristic of the device in this region is calculated. Subsequently, the area ratio is calculated. In this example, it is determined whether or not (an area of a shaded portion / an area of an OK (Pass) zone) is equal to or more than the given reference area ratio, i.e., an area threshold. If it is equal to or more than the area threshold, the device is determined to be "Pass", whereas if it is less than the area threshold, the device is determined to be "Fail".

Also, as yet another determination method, the determination may be made with the use of a resonance point.

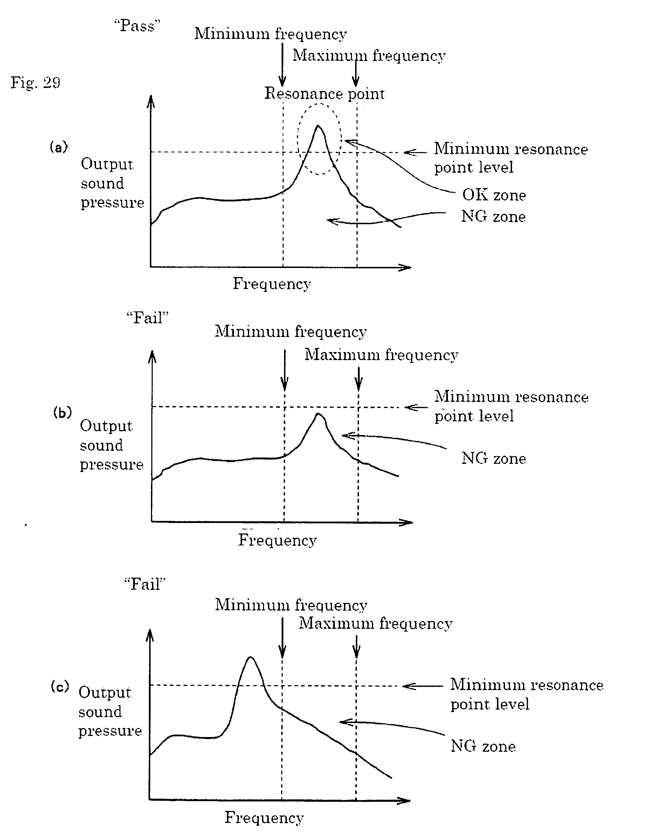

Fig. 29 is a diagram illustrating a case where the allowable range based determination of the output sound pressure is made with the use of the resonance point of the device.

As illustrated in Fig. 29 (a), it is determined whether or not the resonance point exceeds a minimum resonance point level in a given frequency band between minimum and maximum frequencies. If it exceeds the minimum resonance point level, the device is determined to be "Pass".

On the other hand, as illustrated in Fig. 29 (b), if it does not exceed the minimum resonance point level, the device is determined to be "Fail".

Further, as illustrated in Fig. 29 (c), if there is no resonance point in the given frequency band between the minimum and maximum frequencies, the device is also determined to be "Fail".

As described above, based on the method for determining the minute structure according to Embodiment 2, it can be easily determined whether or not the device is within the allowable range, and the devices can be easily classified. This enables a result of the determination for the classification to be used in adjustment of a parameter or the like in a subsequent packaging stage or other stage. Alternatively, in a later delivering stage, it becomes possible to group the devices into some classes according to the classification, so that it becomes possible to provide the device meeting user's desires. Note that the above description gives the various examples of the method for determining the minute structure; however, it should be appreciated that, without limitation to these examples, for example, the determination may be made in combination of them.

Also, in this embodiment, a case where the allowable range based determination is made on the basis of the frequency characteristic of the output sound pressure is described; however, it should be appreciated that, without limitation to this, the above determination method may be applied on the basis of another frequency characteristic representing a characteristic of the device, to thereby determine whether or not the device is within the allowable range.

In addition, a program for instructing a computer to execute any of the determination methods according to the embodiments of the present invention may be preliminarily stored in a storage medium such as a FD, CD-ROM, or hard disk. In this case, the tester may be provided with a driver device for reading the program stored in the storage medium, and the control part 20 may receive the program via the driver device to make the above-described allowable range based determination. Further, in a case of a network connection being made, the program may be downloaded from a server to make the allowable range based determination in the control part 20.

Also, the above describes the method in which the membrane is sucked on the basis of the electrostatic attraction force, as a drive method therefor; however, without limitation to this, a method in which the membrane is sucked with an actuator may also be applied.

Further, the above exemplifies the membrane structure as the test device to give the description; however, without limitation to this, a beam structure may be inspected as the test device according to the above method.

The embodiments disclosed herein should be considered as illustrative rather than limiting in all aspects. The scope of the present invention is shown not by the above description but by the scope of claims, and intended to include meanings equivalent to the scope of claims and all modifications within the scope.

## Claims

1. A minute structure inspection device for evaluating a characteristic of at least one minute structure having a movable portion, the minute structure being formed on a substrate, the minute structure inspection device comprising:
sound wave generating means adapted to output a test sound wave to said minute structure upon testing; and
evaluating means adapted to detect movement of said movable portion of said minute structure in response to said test sound wave outputted by said sound wave generating means, and evaluate said characteristic of said minute structure on a basis of a result of the detection, wherein
said evaluating means evaluates said characteristic of said minute structure on a basis of a comparison between an output voltage outputted on a basis of said movement of said movable portion of said minute structure in at least one given frequency band and an output voltage corresponding to a given threshold.

2. The minute structure inspection device according to claim 1, wherein said given threshold has a first threshold determination level and a second threshold determination level in said given frequency band; and
said evaluating means determines said minute structure to be a good item upon a frequency response characteristic of said outputted output voltage being included between said first and second determination threshold levels in said given frequency band.

3. The minute structure inspection device according to claim 1, wherein said given threshold has a plurality of threshold determination levels in said given frequency band; and
said evaluating means divides a distribution in frequency response characteristic of said outputted output voltage in said given frequency band into a plurality of groups on a basis of said plurality of threshold determination levels, and evaluates quality of said minute structure on a basis of one of said plurality of groups, the one being belonged to by a frequency response characteristic of said outputted output voltage.

4. The minute structure inspection device according to claim 1, wherein said evaluating means divides a distribution in frequency response characteristic of said outputted output voltage in said given frequency band into a plurality of frequency band groups, and evaluates quality of said minute structure on a basis
of one of said plurality of frequency band group, the one being belonged to by a frequency response characteristic of said outputted output voltage.

5. The minute structure inspection device according to any one of claims 1 to 4, wherein said test sound wave has any single frequency.

6. The minute structure inspection device according to any one of claims 1 to 4, wherein said test sound wave has a plurality of any different frequencies.

7. The minute structure inspection device according to claim 6, wherein said test sound wave corresponds to white noise.

8. A minute structure inspection device for evaluating a characteristic of at least one minute structure having a movable portion, the minute structure being formed on a substrate, the minute structure inspection device comprising:
driving means adapted to electrically provide movement to said movable portion of said minute structure; and
evaluating means adapted to detect sound outputted in response to said movement of said minute structure, and evaluate said characteristic of said minute structure on a basis of a result of the detection, wherein
said evaluating means evaluates said characteristic of said minute structure on a basis of a comparison between an output sound pressure outputted on a basis of said movement of said movable portion of said minute structure in at least one given frequency band and an output sound pressure corresponding to a given threshold.

9. The minute structure inspection device according to claim 8, wherein said given threshold has a first threshold determination level and a second threshold determination level in said given frequency band; and
said evaluating means determines said minute structure to be a good item upon a frequency response characteristic of said outputted output sound pressure being included between said first and second threshold determination levels in said given frequency band.

10. The minute structure inspection device according to claim 8, wherein said given threshold has a plurality of threshold determination levels in said given frequency band; and
said evaluating means divides a distribution in frequency response characteristic of said outputted output sound pressure in said given frequency band into a plurality of groups on a basis of said plurality of threshold determination levels, and evaluates quality of said minute structure on a basis of one of said plurality of groups, the one being belonged to by a frequency response characteristic of said outputted output sound pressure.

11. The minute structure inspection device according to any one of claims 8 to 10, wherein said evaluating means divides a distribution in frequency characteristic of said outputted output sound pressure in said given frequency band into a plurality of frequency band groups, and evaluates quality on a basis of one of said plurality of frequency band groups, the one being belonged to by a frequency response characteristic of said outputted output sound pressure.

12. A minute structure inspection method for evaluating a characteristic of at least one minute structure having a movable portion, the minute structure being formed on a substrate, the minute structure inspection method comprising the steps of:
outputting a test sound wave to said minute structure upon testing;
detecting movement of said movable portion of said minute structure in response to said test sound wave outputted by sound wave generating means; and
evaluating said characteristic of said minute structure on a basis of a result of the detection, wherein
said evaluating step evaluates said characteristic of said minute structure on a basis of a comparison between a detected output voltage in at least one given frequency band and an output voltage corresponding to a given threshold.

13. The minute structure inspection method according to claim 12, wherein said given threshold has a first threshold determination level and a second threshold determination level in said given frequency band; and
said evaluating step determines said minute structure to be a good item upon a frequency response characteristic of said detected output voltage being included between said first and second threshold determination levels in said given frequency band.

14. The minute structure inspection method according to claim 12, wherein said given threshold has a plurality of threshold determination levels in said given frequency band;
a distribution in frequency response characteristic of said detected output voltage in said given frequency band is divided into a plurality of groups on a basis of said plurality of threshold determination levels; and
said evaluating step evaluates quality on a basis of one of said plurality of groups, the one being belonged to by a frequency response characteristic of said detected output voltage.

15. The minute structure inspection method according to claim 12, wherein a distribution in frequency response characteristic of said detected output voltage in said given frequency band is divided into a plurality of frequency band groups; and
said evaluating step evaluates quality on a basis of one of said plurality of frequency band groups, the one being belonged to by a frequency response characteristic of said detected output voltage.

16. The minute structure inspection method according to claim 12, wherein said test sound wave has any single frequency.

17. The minute structure inspection method according to claim 12, wherein said test sound wave has a plurality of any different frequencies.

18. The minute structure inspection method according to claim 17, wherein said test sound wave corresponds to white noise.

19. A minute structure inspection method for evaluating a characteristic of at least one minute structure having a movable portion, the minute structure being formed on a substrate, the minute structure inspection method comprising the steps of:
electrically providing movement to said movable portion of said minute structure;
detecting sound outputted in response to said movement of said minute structure; and
evaluating said characteristic of said minute structure on a basis of a result of the detection, wherein
said evaluating step evaluates said characteristic of said minute structure on a basis of a comparison between a detected output sound pressure in at least one given frequency band and an output sound pressure corresponding to a given threshold.

20. The minute structure inspection method according to claim 19, wherein said given threshold has a first threshold determination level and a second threshold determination level in said given frequency band; and
said evaluating step determines said minute structure to be a good item upon a frequency response characteristic of said detected output sound pressure being included between said first and second threshold determination levels in said given frequency band.

21. The minute structure inspection method according to claim 19, wherein said given threshold has a plurality of threshold determination levels in said given frequency band;
a distribution in frequency response characteristic is divided into a plurality of groups on a basis of said plurality of threshold determination levels for said detected output sound pressure in said given frequency band; and
said evaluating step evaluates quality on a basis of one of said plurality of groups, the one being belonged to by a frequency response characteristic of said detected output sound pressure in said given frequency band.

22. The minute structure inspection method according to claim 19, wherein a distribution in frequency response characteristic of said detected output sound pressure in said given frequency band is divided into a plurality of frequency band groups; and
said evaluating step evaluates quality on a basis of one of said plurality of frequency band groups, the one being belonged to by a frequency response characteristic of said detected output sound pressure.

23. A minute structure inspection program for instructing a computer to execute the minute structure inspection method according to any one of claims 12 to 22.

24. A minute structure inspection device for evaluating a characteristic of at least one minute structure having a movable portion, the minute structure being formed on a substrate, the minute structure inspection device comprising:
driving means adapted to electrically provide movement to said movable portion of said minute structure; and
evaluating means adapted to detect sound outputted in response to said movement of said minute structure, and evaluate said characteristic of said minute structure on a basis of a result of the detection, wherein
said evaluating means calculates an occupied area of a given region surrounded by an output sound pressure characteristic based on said movement of said movable portion of said minute structure, to thereby calculate an occupancy rate, the output sound pressure characteristic being between a minimum characteristic level and a maximum characteristic level and in a given frequency band, and evaluates said characteristic of said minute structure on a basis of a comparison between said occupancy rate and an occupancy rate corresponding to a given threshold.
